# DEMANDE DE BREVET EUROPEEN

(11) **EP 1 739 749 A2**
(43) Date de publication de la demande: **03.01.2007**
(21) Numéro de dépôt: 06116328.3
(22) Date de dépôt: 29.06.2006
(51) Int. Cl.: H01L 27/108, H01L 21/8242, H01L 29/78

(54) **Cellule mémoire à un transistor MOS à corps isolé à effet mémoire prolongé**

(30) Priorité: 30.06.2005 FR 0551837
(71) Demandeur: STMicroelectronics ( Crolles 2) SAS, 38920 Crolles (FR)
(72) Inventeur: Ranica, Rossella, 38000 GRENOBLE (FR); Villaret, Alexandre, 38000 GRENOBLE (FR); Mazoyer, Pascale, 38420 DOMENE (FR)
(74) Mandataire: de Beaumont, Michel

(57) **Abrégé**

L'invention concerne une cellule mémoire à un transistor MOS formé dans une région de corps flottant (1), dans laquelle la surface inférieure des régions de source et de drain (9-1, 10-1), en dehors des régions d'extension de source et d'extension de drain (9-2, 10-2), repose sur une couche isolante (51, 52).

## Description

### Domaine de l'invention

La présente invention concerne des cellules mémoire de type DRAM à un transistor formé dans un caisson ou corps flottant délimité dans le sens de la profondeur par une jonction.

### Exposé de l'art antérieur

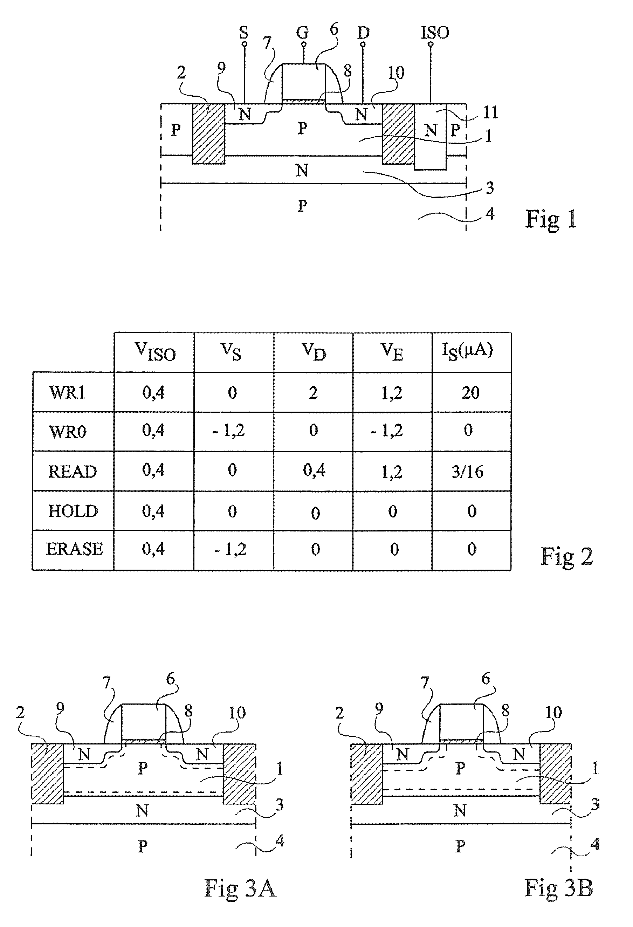

La figure 1 est une vue en coupe schématique d'un exemple d'une telle cellule mémoire. Cette cellule comprend un transistor MOS à canal N formé dans une région de corps flottant 1 délimitée latéralement par un anneau isolant 2 et, dans le sens de la profondeur, par une couche 3 de type N formée dans un substrat 4 de type P. Le transistor MOS comprend, de part et d'autre d'une région de grille 6 entourée d'espaceurs 7 et reposant sur un isolant de grille 8, des régions de source et de drain 9 et 10 de type N. Chacune des régions de source et de drain comprend une région plus dopée et plus profonde à l'extérieur de la région définie par les espaceurs 7 et une région moins dopée et moins profonde sous les espaceurs 7.

En l'absence d'action spécifique sur la cellule, le corps flottant 1 est à un potentiel donné correspondant à l'équilibre thermodynamique. Il a été montré que l'on pouvait injecter dans ce corps des charges positives ou négatives, mettant la cellule dans l'un ou l'autre de deux états déterminés que l'on appellera 1 et 0. En fonction de cette polarisation du substrat, la tension de seuil du transistor se modifie et l'on peut donc distinguer les états 1 et 0.

En outre, la figure 1 représente un puits conducteur 11 de type N rejoignant la couche enterrée 3 pour permettre de la polariser. Dans la figure, la borne de polarisation est appelée ISO, la couche enterrée 3 pouvant être appelée couche d'isolement.

La figure 2 est un tableau illustrant les tensions à appliquer à la cellule dans divers modes de fonctionnement de celle-ci. On a plus particulièrement indiqué les tensions VISO à appliquer sur la couche enterrée 3, VS à appliquer sur la source, VD à appliquer sur le drain, et VG à appliquer sur la grille. Dans la colonne de droite on a indiqué le courant de conduction du transistor mesuré dans ces divers états, désigné par IS et exprimé en microampères alors que toutes les tensions sont exprimées en volts. Plus particulièrement, on a distingué des états d'écriture d'un 1 (WR1), d'écriture d'un 0 (WR0), de lecture (READ), de maintien ou rétention (HOLD), et d'effacement (ERASE). Les valeurs données dans ce tableau le sont uniquement à titre d'exemple et correspondent à une technologie particulière. On retiendra essentiellement les valeurs relatives des diverses tensions et leurs polarités. L'exemple donné correspond à une technologie dans laquelle la dimension minimum possible d'un motif est de l'ordre de 0,12 µm, dans laquelle on a choisi une longueur de grille de l'ordre de 0,30 µm et une profondeur des régions d'isolement STI 2 de l'ordre de 0,35 µm ainsi qu'une épaisseur d'oxyde de grille de l'ordre de 6 nm.

Ainsi, les principaux états de la cellule sont les suivants.
- Ecriture d'un 1 (WR1). Le transistor MOS est mis dans un état de conduction relativement fort (courant de l'ordre de 20 µA). Cet état peut être établi pendant seulement une très brève durée, par exemple de l'ordre de quelques nanosecondes. A la fin de cet état, quand toutes les tensions appliquées sont ramenées à zéro, sauf la tension de couche enterrée qui est maintenue de préférence à une valeur faiblement positive par exemple 0,4 volt, la cellule mémoire est dans l'état illustré en figure 3A, à savoir que des charges positives se sont accumulées dans le corps flottant. Une fois la cellule mémoire à l'état d'équilibre thermodynamique, ces charges tendent, comme cela est illustré, à rétrécir les zones de charge d'espace. Le transistor a alors une tension de seuil faible, c'est-à-dire que, si l'on se met dans un état de lecture dans lequel le transistor est faiblement polarisé à l'état passant, on observera pour une tension de grille donnée un premier courant (16 µA dans l'exemple illustré).
- Ecriture d'un 0 (WR0). Le transistor est bloqué, sa grille étant mise à un potentiel négatif, et sa source (ou son drain) est également mis à un potentiel négatif, d'où il résulte que les charges positives éventuellement présentes dans le substrat sont éliminées et que des charges négatives sont injectées par suite de la mise à l'état passant de la diode corps-source ou corps-drain. A la fin de cet état, de la façon illustrée en figure 3B, les zones de charge d'espace ont tendance à s'élargir et ceci entraîne que la tension de seuil du transistor augmente. Ainsi, si l'on se met dans des conditions de lecture dans lesquelles le transistor est faiblement polarisé à l'état passant, on obtient pour une même tension de grille de 1,2 V que celle considérée dans le cas précédent, un courant plus faible que le courant à l'état 1 (3 pA au lieu de 16 pA dans l'exemple illustré).
- Lecture (READ). Le transistor MOS est mis dans un état faiblement passant, le drain étant par exemple seulement à une tension de l'ordre de 0,4 V pour limiter les injections susceptibles de déprogrammer le transistor. Le courant traversant le transistor MOS est mesuré ou, de préférence, comparé à une valeur de référence comprise entre les valeurs de courant correspondant aux états 1 et 0.
- Maintien (HOLD). Aucune tension n'est appliquée au transistor. La tension appliquée à la couche enterrée 3 est de préférence maintenue légèrement positive pour mieux bloquer la jonction entre le corps isolé et cette couche enterrée dans le cas où le transistor est programmé à l'état 1.
- Effacement (ERASE). La jonction source/corps (ou drain/corps) est polarisée dans le sens passant ce qui permet l'évacuation des charges positives. La couche enterrée 3 reste faiblement polarisée positivement.
   Ainsi, comme on l'a exposé précédemment, l'effet mémoire d'une cellule selon la présente invention se caractérise par une différence entre un courant à l'état 1 et un courant à l'état 0 pour une polarisation drain-source donnée et pour une tension de grille donnée.

### Résumé de l'invention

Un objet de la présente invention est d'améliorer l'effet mémoire d'une cellule mémoire à un transistor MOS à corps flottant.

Un autre objet de la présente invention est de prévoir une telle cellule mémoire qui est moins susceptible de dégradation de son état 1 alors qu'elle est ou qu'elle passe dans un état de maintien.

Pour atteindre ces objets, la présente invention prévoit une cellule mémoire à un transistor MOS formé dans une région de corps flottant, dans laquelle la surface inférieure des régions de source et de drain, en dehors des régions d'extension de source et d'extension de drain, repose sur une couche isolante.

Selon un mode de réalisation de la présente invention, la région du corps flottant est isolée sur sa face inférieure par une jonction.

Selon un mode de réalisation de la présente invention, la région du corps flottant est isolée latéralement par des tranchées isolantes.

La présente invention vise aussi un circuit intégré contenant une cellule mémoire du type ci-dessus.

La présente invention vise aussi un procédé de fabrication d'une cellule mémoire du type ci-dessus, comprenant les étapes consistant à former sur une zone active de silicium délimitée par une tranchée isolante une couche monocristalline de SiGe et une couche monocristalline de silicium ; graver la périphérie de la couche de SiGe sous la couche de silicium en laissant en place la couche de SiGe sensiblement sous la région de grille d'un transistor MOS formé dans la couche de silicium ; et remplir l'évidement périphérique d'une couche isolante. Les couches monocristallines de SiGe et de silicium peuvent être dopées in situ.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une cellule mémoire à un transistor à corps flottant ;
la figure 2 est un tableau illustrant des exemples de tensions appliquées à la cellule de la figure 1 dans différents états ;
la figure 3A représente la structure de la figure 1 dans l'état de maintien après écriture d'un état 1 ;
la figure 3B représente la structure de la figure 1 dans l'état de maintien après écriture d'un état 0 ;
la figure 4 est une vue en coupe schématique d'une cellule mémoire selon un mode de réalisation de la présente invention ; et

Les figures 5A à 5E sont des vues en coupe illustrant un exemple d'étapes successives de fabrication d'une cellule mémoire selon la présente invention.

Comme cela est habituel dans la représentation des circuits intégrés, les diverses vues en coupe ne sont pas tracées à l'échelle.

### Description détaillée

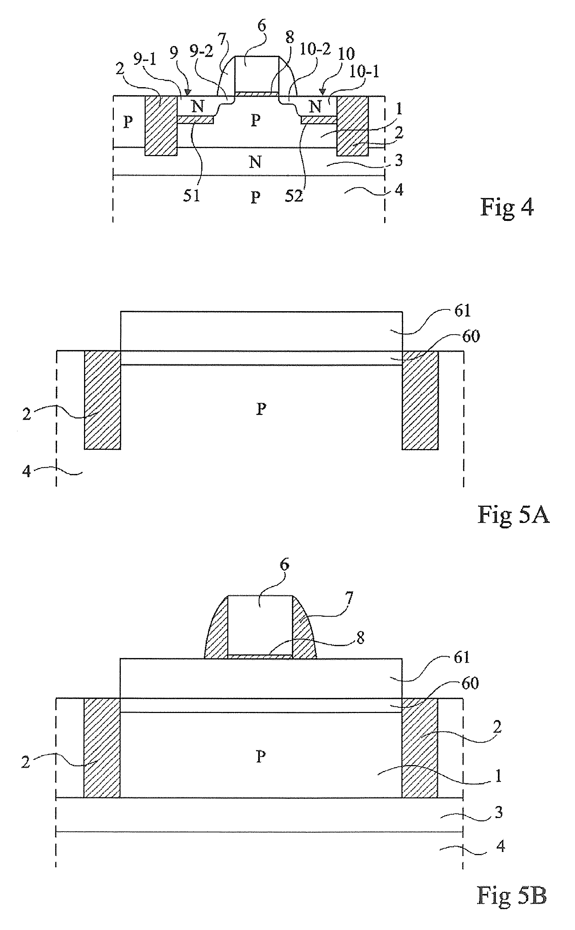

La figure 4 représente une cellule mémoire selon un mode de réalisation de la présente invention représentée sensiblement de la même façon que la cellule de l'art antérieur illustrée en figure 1. Toutefois, on s'est abstenu de représenter en figure 4 la région conductrice 11 de reprise de contact de couche enterrée. On pourra considérer que cette région est située dans un plan autre que le plan de coupe de la figure ou qu'il est prévu une seule région de reprise de contact pour un bloc de cellules mémoire selon la présente invention.

Pour la source 9, on a désigné par la référence 9-1 la région de contact de source, généralement transformée dans sa partie supérieure en un siliciure pour faciliter les contacts et par la référence 9-2 la région d'extension de source 9-2 plus faiblement dopée, s'étendant sensiblement sous l'espaceur 7. De même, pour le drain 10, des références 10-1 et 10-2 ont été utilisées pour désigner la région de contact de drain 10-1 et la région d'extension de drain 10-2 s'étendant sous l'espaceur 7.

Selon la présente invention, il est prévu des couches isolantes 51 et 52 sous au moins une partie principale des régions de contact de source et de drain, sensiblement seules les régions d'extension de source et d'extension de drain étant en contact avec la région de corps flottant 1.

Le fait de prévoir cet isolement de la partie inférieure des régions de source et de drain présente plusieurs avantages et notamment les avantages suivants.
- Augmentation de l'effet mémoire de la cellule. Toutes choses égales d'ailleurs, la différence entre le courant de lecture d'une cellule programmée à 1 et le courant de lecture d'une cellule programmé à 0 augmente. On considère que ce phénomène est dû à l'augmentation du rapport entre, d'une part, la surface de la jonction de la région de corps flottant 1 avec la couche enterrée 3 et, d'autre part, la somme des surfaces de jonction entre les régions de source 9 et de drain 10 et la région de corps flottant 1.
- Réduction des fuites pendant la phase de maintien ou de rétention et lors du passage d'une phase de programmation à 1 à un état de maintien. En effet, les fuites se produisent essentiellement au niveau des jonctions entre la région de corps flottant et les régions de source et de drain. Puisque la jonction entre la région de corps flottant et la région de couche enterrée est maintenue polarisée en inverse pour mieux bloquer les fuites, la surface de fuite est en pratique limitée aux zones d'extension de source et de drain.

On notera également que les avantages susmentionnés n'entraînent pas d'inconvénients. Notamment, au moment de la programmation, ce sont essentiellement les régions d'extension de drain et de source qui produisent l'injection de porteurs dans la région de corps flottant et ces régions d'extension de source et de drain ne sont pas affectées selon la présente invention.

Les figures 5A à 5E représentent à titre d'exemple un mode de réalisation possible de la structure de la figure 4.

On part d'un substrat 4, de type P dans lequel des régions actives sont délimitées par des tranchées peu profondes remplies d'un isolant (STI) 2.

A l'étape illustrée en figure 5A, on procède au dépôt épitaxial d'une couche 60 d'un cristal, par exemple du SiGe, pouvant croître de façon monocristalline sur du silicium monocristallin et sur lequel du silicium peut croître de façon monocristalline. On procède ensuite au dépôt par épitaxie sur la couche de SiGe d'une couche de silicium 61 d'une épaisseur correspondant à l'épaisseur que l'on veut obtenir pour les zones de contact de source et de drain.

A l'étape illustrée en figure 5B, on procède à une implantation de type N, en une ou plusieurs étapes, pour former la couche enterrée 3 sur l'ensemble de la matrice mémoire. On forme alors sur la couche 61 un motif de grille comprenant une grille conductrice 6, couramment en silicium polycristallin, entourée d'espaceurs 7 et reposant sur une mince couche d'isolant de grille 8.

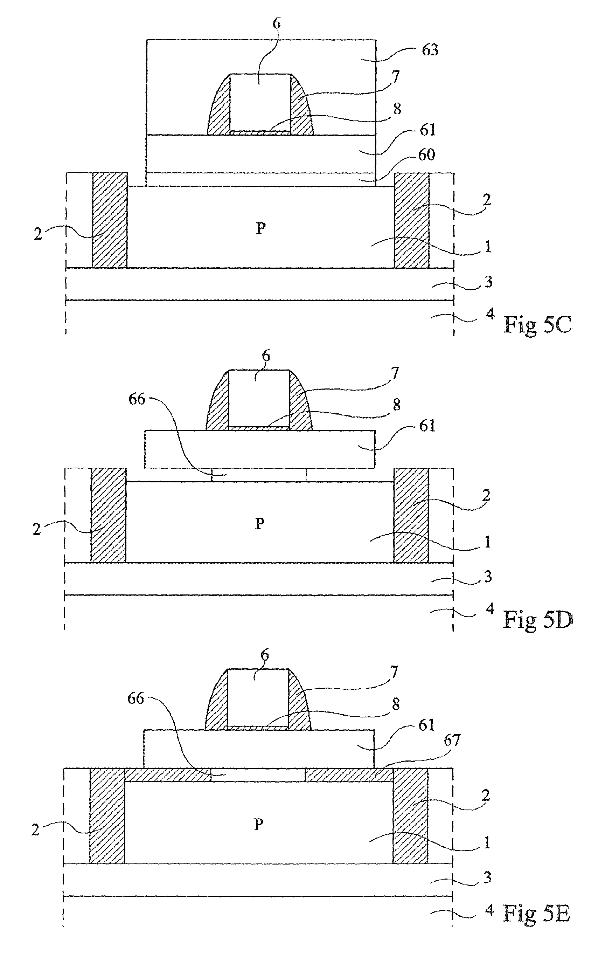

A l'étape illustrée en figure 5C, on dépose un masque 63, par exemple un masque de résine, qui est gravé selon un motif de surface inférieure à celle d'une zone active. A l'aide de ce masque, on grave les couches 61 et 60, de façon que les bords périphériques de la couche 60 soient dégagés.

A l'étape illustrée en figure 5D, on prolonge la gravure de la couche de SiGe 60 de façon à laisser en place seulement une petite portion 66 sensiblement à l'aplomb de la zone de grille.

A l'étape illustrée en figure 5E, on procède à un remplissage par un isolant 67, par exemple de l'oxyde ou du nitrure de silicium, de la région située sous la couche de silicium 61.

On arrive ainsi à une structure correspondant à celle représentée en figure 4.

L'homme de l'art aura bien entendu noté qu'il conviendra de réaliser les régions d'extension de drain à l'étape illustrée en figure 5B, avant la formation des espaceurs 7, et que les régions de source et de drain pourront être réalisées à l'une ou l'autre des étapes de fabrication selon la filière technologique utilisée. Par ailleurs, l'homme de l'art notera qu'il conviendra de veiller à ce que les couches de SiGe 60 et de silicium 61 soient dopées de type P sensiblement comme le substrat 4 et plus particulièrement la partie de corps flottant 1 formée au-dessus de la région 3 d'implantation N. Le dopage de ces diverses couches 60 et 61 pourra être fait de diverses manières connues de l'homme de l'art, par exemple in situ lors du dépôt, ou ensuite par des étapes d'implantation-diffusion. Par ailleurs, on notera que ceci permet d'optimiser le dopage de la couche de type P 61 pour un fonctionnement optimal d'injection par les régions de source et de drain.

A titre d'exemple, on peut prévoir que la couche de SiGe 60, et donc les couches isolantes 67 ont une épaisseur de l'ordre de 20 nm dans la technologie décrite précédemment.

La présente invention est susceptible de diverses variantes et modifications qui apparaîtront à l'homme de l'art. Notamment, les matériaux et les dimensions indiqués pourront être modifiés selon la technologie utilisée, du moment que les fonctions décrites sont atteintes. En outre, bien que l'on ait décrit ici un transistor MOS à canal N, la cellule mémoire pourra comprendre un transistor MOS à canal P, les types de conductivité et les polarités des charges étant modifiés en conséquence.

On notera que la présente invention peut également s'appliquer avantageusement à une cellule mémoire de type DRAM à un transistor formé dans un caisson ou corps flottant délimité dans le sens de la profondeur par une couche isolante (SOI).

## Revendications

1. Cellule mémoire à un transistor MOS formé dans une région de corps flottant (1) isolée sur sa face inférieure par une jonction, **caractérisée en ce que** la surface inférieure des régions de source et de drain (9-1, 10-1), en dehors des régions d'extension de source et d'extension de drain (9-2, 10-2), repose sur une couche isolante (51, 52).

2. Cellule mémoire selon la revendication 1, dans laquelle la région du corps flottant est isolée latéralement par des tranchées isolantes (2).

3. Circuit intégré contenant une cellule mémoire selon la revendication 1.

4. Procédé de fabrication d'une cellule mémoire selon la revendication 1, comprenant les étapes suivantes:
former sur une zone active de silicium délimitée par une tranchée isolante une couche monocristalline de SiGe (60) et une couche monocristalline de silicium (61) ;
graver la périphérie de la couche de SiGe (60) sous la couche de silicium (61) en laissant en place la couche de SiGe sensiblement sous la région de grille d'un transistor MOS formé dans la couche de silicium (61) ; et
remplir l'évidement périphérique d'une couche isolante (67).

5. Procédé selon la revendication 4, comprenant le dopage in situ desdites couches monocristallines de SiGe (60) et de silicium (61).
